# DEMANDE DE BREVET EUROPEEN

(11) **EP 2 199 809 A1**
(43) Date de publication de la demande: **23.06.2010**
(21) Numéro de dépôt: 09354050.8
(22) Date de dépôt: 17.11.2009
(51) Int. Cl.: G01R 15/06, H01G 4/232, H01G 4/30, H01L 23/64, H01L 27/08, H02H 7/08

(54) **Dispositif diviseur capacitif, capteur de tension, module de déclencheur et appareil de protection électrique pourvus d'un tel dispositif**

(30) Priorité: 18.12.2008 FR 0807110
(71) Demandeur: Schneider Electric Industries SAS, 92500 Rueil-Malmaison (FR)
(72) Inventeur: Moliton, Vivien, 38050 Grenoble Cedex 09 (FR); Vincent, François, 38050 Grenoble Cedex 09 (FR)
(74) Mandataire: Mérigeault, Thierry Louis Henri

(57) **Abrégé**

Un diviseur capacitif multicouche (1) comprenant une première et une seconde électrode principale (3, 4) formées sur un même niveau (8) pour appliquer une tension d'entrée, et une électrode commune (6) formée sur un autre niveau (9) pour fournir une tension atténuée (VS), ledit dispositif comportant au moins une première électrode auxiliaire (11) formée sur encore un autre niveau (21), lesdites électrodes étant disposées pour former des unités capacitives, ladite électrode auxiliaire (11) s'étendant vers un côté dudit dispositif vers lequel est disposée la seconde électrode principale (4), de façon à connecter ladite électrode auxiliaire à la seconde électrode principale par l'entremise d'un conducteur linéaire (31; 55).

Un capteur de tension, un module de déclencheur et un appareil de protection électrique pourvus d'un tel dispositif.

## Description

### DOMAINE TECHNIQUE DE L'INVENTION

L'invention relève du domaine des condensateurs formés dans une structure multicouche, et en particulier des diviseurs capacitifs formés dans une telle structure.

L'invention concerne un dispositif diviseur capacitif destiné à atténuer une tension d'entrée, ledit dispositif comportant des électrodes formées sur différents niveaux d'une structure multicouche séparés par des couches isolantes, lesdites électrodes incluant une première et une seconde électrode principale pour appliquer ladite tension d'entrée, et une électrode commune pour fournir une tension atténuée à partir de ladite tension d'entrée.

L'invention concerne également un capteur de tension, un module de déclencheur et un appareil de protection électrique pourvus d'un tel dispositif diviseur capacitif.

### ÉTAT DE LA TECHNIQUE

La demande de brevet européen EP 0631144 décrit un capteur de tension comportant deux réseaux diviseurs capacitifs équipés de bornes communes destinées à fournir une tension atténuée, lesdits réseaux comportant des condensateurs connectés en série et intégrés dans des structures multicouches. Dans ces structures multicouches, les électrodes de ces condensateurs sont formées par des couches en polysilicone réparties sur deux niveaux, se recouvrant au moins partiellement et étant électriquement isolées par une couche diélectrique.

Un inconvénient des diviseurs capacitifs de l'art antérieur est qu'ils présentent une relativement forte impédance de sortie. De plus, ces diviseurs capacitifs sont formés sur des structures multicouches présentant un encombrement significatif directement fonction du nombre de condensateurs montés en série.

### EXPOSÉ DE L'INVENTION

L'invention vise à remédier aux problèmes techniques des diviseurs capacitifs de l'art antérieur en proposant un dispositif diviseur capacitif destiné à atténuer une tension d'entrée, ledit dispositif comportant des électrodes formées sur différents niveaux d'une structure multicouche séparés par des couches isolantes, lesdites électrodes incluant une première et une seconde électrode principale pour appliquer ladite tension d'entrée, et une électrode commune pour fournir une tension atténuée à partir de ladite tension d'entrée, ledit diviseur capacitif étant **caractérisé en ce que** lesdites première et seconde électrodes principales sont formées sur un même niveau de ladite structure, l'électrode commune étant formée sur un autre niveau de ladite structure, ladite électrode commune étant disposée pour former avec la première électrode principale une première unité capacitive, et pour former avec la seconde électrode principale une seconde unité capacitive, en ce que ledit dispositif comporte au moins une première électrode auxiliaire formée sur encore un autre niveau de la structure multicouche et disposée pour former avec l'électrode commune une première unité capacitive auxiliaire, et en ce que ladite électrode auxiliaire et la seconde électrode principale, s'étendent vers un côté de la structure multicouche de façon à connecter électriquement ladite électrode auxiliaire à la seconde électrode principale par l'entremise d'un conducteur linéaire.

De préférence, l'électrode commune est formée sur un niveau consécutif par rapport au niveau des dites première et seconde électrodes principales.

De préférence, le dispositif diviseur capacitif comporte une pluralité d'électrodes auxiliaires formées sur des niveaux spécifiques de la structure multicouche, chaque électrode auxiliaire étant disposée pour former, avec l'électrode auxiliaire formée sur un niveau spécifique consécutif, une unité capacitive auxiliaire, lesdites électrodes auxiliaires étant connectées soit à la seconde électrode principale, soit à l'électrode commune de façon à obtenir une connexion en parallèle de chaque unité capacitive auxiliaire avec la seconde unité capacitive.

Selon un mode de réalisation, le dispositif diviseur capacitif comporte un nombre prédéterminé N d'électrodes auxiliaires formées sur les niveaux spécifiques de la structure multicouche présentant des rangs allant de 1 à N, le niveau spécifique de la première électrode auxiliaire correspondant au rang 1, une électrode auxiliaire disposée sur un niveau spécifique de rang impair étant connectée à la seconde électrode principale, une électrode auxiliaire disposée sur un niveau spécifique de rang pair étant connectée à l'électrode commune. Avantageusement, chaque électrode auxiliaire formée sur un niveau spécifique de rang impair s'étend vers le côté de la structure multicouche dans lequel est disposée la seconde électrode principale, chaque électrode auxiliaire formée sur un niveau spécifique de rang pair et l'électrode commune s'étendant vers un côté latéralement opposé, de façon à connecter les électrodes entre elles par l'entremise de conducteurs linéaires. Préférentiellement, au moins un conducteur linéaire traverse des niveaux consécutifs de la structure multicouche.

De préférence, les niveaux spécifiques de chaque électrode auxiliaire correspondent à des niveaux consécutifs de la structure multicouche.

L'invention concerne également un capteur de tension comportant :
- deux bornes d'entrée d'une tension d'entrée,
- un dispositif diviseur capacitif connecté aux dites bornes d'entrée pour fournir une tension atténuée en fonction de ladite tension d'entrée, et
- un circuit de traitement connecté au dit dispositif diviseur pour fournir un signal représentatif de ladite tension d'entrée,
ledit capteur étant **caractérisé en ce que** ledit dispositif diviseur capacitif est un diviseur tel que décrit précédemment, lesdites bornes d'entrée étant respectivement connectées à la première et à la seconde électrode principale, ledit circuit de traitement étant connecté à l'électrode commune.

De préférence, le circuit de traitement du capteur de tension comporte des moyens d'adaptation d'impédance. Avantageusement les moyens d'adaptation d'impédance comportent une résistance montée en parallèle avec l'unité capacitive, la valeur de ladite résistance étant choisie de façon à minimiser la fréquence de coupure par rapport à la fréquence d'utilisation.

L'invention concerne également un module de déclencheur pour appareil de protection électrique, ledit module comprenant au moins un capteur de courant pour mesurer le courant circulant dans au moins un conducteur électrique protégé par ledit appareil et des moyens de traitement pour fournir un signal de déclenchement en fonction de la valeur dudit courant, ledit module étant **caractérisé en ce qu**'il comporte un capteur de tension tel que décrit précédemment, lesdits moyens de traitement comportant des moyens de détermination d'une puissance et/ou d'un facteur de puissance connectés au dit capteur de courant et au dit capteur de tension, ledit signal de déclenchement étant fonction, entre autres, de la valeur de ladite puissance et/ou dudit facteur de puissance.

L'invention concerne également un appareil de protection électrique destiné à être installé sur au moins un conducteur électrique, ledit appareil comprenant un contact mobile, un mécanisme de commande d'ouverture ou de fermeture dudit contact mobile, et un déclencheur coopérant avec ledit mécanisme pour déclencher l'ouverture dudit contact mobile en réponse à un défaut électrique, ledit appareil étant **caractérisé en ce que** ledit déclencheur comprend un module de déclencheur tel que décrit précédemment, ledit module étant pourvu d'un capteur de tension et d'un capteur de courant.

L'invention concerne également un appareil de protection électrique destiné à être installé sur au moins un conducteur électrique, ledit appareil comprenant un contact mobile, un mécanisme de commande d'ouverture ou de fermeture dudit contact mobile, et un déclencheur coopérant avec ledit mécanisme pour déclencher l'ouverture dudit contact mobile en réponse à un défaut électrique, ledit déclencheur comprenant un capteur de courant pour mesurer le courant circulant dans ledit conducteur électrique et des moyens de traitement pour fournir un signal de déclenchement fonction dudit courant, ledit appareil étant **caractérisé en ce que** le déclencheur comprend, en outre, un capteur de tension tel que décrit précédemment, lesdits moyens de traitement comportant des moyens de détermination d'une puissance et/ou d'un facteur de puissance connectés au dit capteur de courant et au dit capteur de tension, ledit signal de déclenchement étant fonction de ladite valeur de la puissance et/ou dudit facteur de puissance.

### BRÈVE DESCRIPTION DES FIGURES

La figure 1 représente une structure multicouche d'un diviseur capacitif selon un mode de réalisation de l'invention.
La figure 2 est une représentation équivalente de la structure multicouche de la figure 1.
La figure 3 représente un autre mode de réalisation d'un diviseur capacitif comportant une impédance de sortie réduite par rapport au mode représenté à la figure 1.
La figure 4 est une représentation équivalente de la structure multicouche de la figure 3.
La figure 5 est une vue schématique d'un appareil de protection électrique selon l'invention.
La figure 6 représente un premier mode de réalisation des moyens d'adaptation d'impédance d'un capteur de tension selon l'invention.
La figure 7 représente un second mode de réalisation des moyens d'adaptation d'impédance d'un capteur de tension selon l'invention.
La figure 8 est une vue en perspective d'un appareil de protection électrique selon un mode de réalisation de l'invention.
La figure 9 est une vue en perspective des internes d'un module du déclencheur de l'appareil de protection électrique représenté à la figure 8.
La figure 10 est une vue en perspective montrant les capteurs de courant et les capteurs de tension du module représenté à la figure 9.
La figure 11 est une vue en perspective montrant les conducteurs électriques sur lesquels sont montés les capteurs de courant et les capteurs de tension du module représenté à la figure 9.

### DESCRIPTION DETAILLEE D'UN MODE DE RÉALISATION

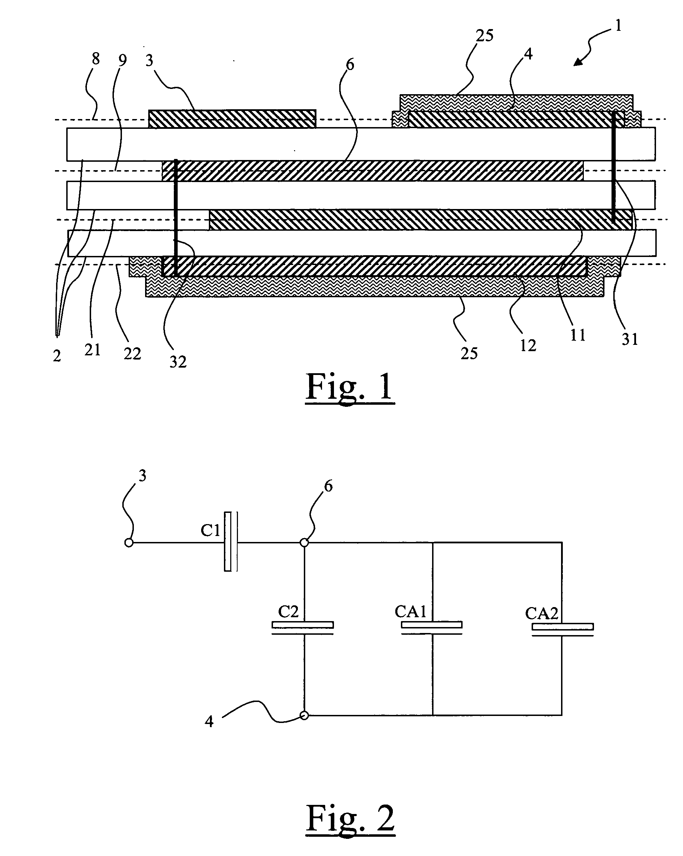

En référence à la figure 1, le diviseur capacitif est formé dans une structure multicouche 1 comportant des électrodes sur plusieurs niveaux séparés par des couches isolantes 2. Les électrodes du diviseur capacitif incluent une première électrode principale 3 et une seconde électrode principale 4 permettant d'appliquer une tension d'entrée VE. La première et la seconde électrode principale peuvent être également qualifiées respectivement d'électrode potentielle et d'électrode mesure. La structure multicouche 1 comporte également une électrode commune 6 pour fournir une tension atténuée VS à partir de la tension d'entrée VE. Plus précisément, la tension atténuée est généralement fournie entre l'électrode commune 6 et la seconde électrode 4.

Comme cela est visible sur la figure 1, les première et seconde électrodes principales 3, 4 sont formées sur un même niveau 8 de la structure multicouche 1. L'électrode commune 6 est, quant à elle, formée sur un autre niveau 9 de la structure multicouche.

Comme cela est visible sur la figure 2, l'électrode commune 6 est disposée pour former avec la première électrode principale 3 une première unité capacitive C1, et pour former avec la seconde électrode principale 4 une seconde unité capacitive C2.

Plus précisément, dans le mode représenté à la figure 1, l'électrode commune 6 est formée sur un niveau 9 consécutif par rapport au niveau 8 des dites première et seconde électrodes principales. En d'autres termes, l'électrode commune 6 est disposée en vis-à-vis avec chacune des première et seconde électrodes principales 3, 4. La première unité capacitive est donc formée par la première électrode principale 3, l'électrode commune 6 et la couche isolante 2 séparant lesdites électrodes. De la même façon, la seconde unité capacitive est formée par la seconde électrode principale 4, l'électrode commune 6 et la couche isolante 2 séparant lesdites électrodes. Ainsi, les unités capacitives représentées sur la figure 2 correspondent à deux condensateurs C1, C2 comportant une armature commune essentiellement constituée par l'électrode commune 6.

Dans d'autres modes de réalisation non représentés, l'électrode commune pourrait être formée sur un niveau non consécutif par rapport au niveau des dites première et seconde électrodes principales, c'est-à-dire sur un niveau plus éloigné par rapport au niveau des dites première et seconde électrodes principales, en interposant entre ces deux niveaux plusieurs couches isolantes et éventuellement des électrodes intermédiaires. Par exemple, au moins une partie des électrodes intermédiaires pourraient être disposées pour former, avec la première électrode principale et l'électrode commune, une première unité capacitive correspondant à des condensateurs montés en série. De la même façon, au moins une partie des électrodes intermédiaires pourraient être disposées pour former avec la seconde électrode principale et l'électrode commune, une seconde unité capacitive correspondant à des condensateurs montés en série. Un tel mode de réalisation permettrait, entre autres, de répartir la tension appliquée entre chaque électrode principale et l'électrode commune sur plusieurs condensateurs montés en série, de sorte que le diviseur capacitif pourrait encaisser des tensions plus élevées.

Le diviseur capacitif représenté sur la figure 1 comporte, en outre, deux électrodes auxiliaires 11, 12 formées sur d'autres niveaux spécifiques de la structure multicouche, en l'occurrence sur les niveaux spécifiques référencés 21 et 22. Par niveau spécifique, on entend un des niveaux de la structure multicouche dont la spécificité est qu'il comporte une électrode auxiliaire. La première électrode auxiliaire 11 est disposée pour former avec l'électrode commune 6 une première unité capacitive auxiliaire. Plus précisément, la première électrode auxiliaire 11 est formée sur un niveau spécifique 21 qui correspond à un niveau consécutif par rapport au niveau 9 sur lequel est formée l'électrode commune 6. En d'autres termes, la première électrode auxiliaire 11 est disposée en vis-à-vis avec l'électrode commune 6. Ainsi, la première unité capacitive auxiliaire représentée sur la figure 2 correspond à un condensateur CA1 comportant une armature commune avec le condensateur C2.

En ce qui concerne la seconde électrode auxiliaire 12, elle est disposée pour former, avec l'électrode auxiliaire formée sur le niveau spécifique 22, une seconde unité capacitive auxiliaire. Plus précisément, la seconde électrode auxiliaire 12 est formée sur un niveau spécifique 22 correspondant à un niveau consécutif par rapport au niveau 21 sur lequel est formée la première électrode auxiliaire 11, c'est-à-dire que les électrodes auxiliaires 11, 12 sont disposées en vis-à-vis. Ainsi, la seconde unité capacitive auxiliaire représentée sur la figure 2 correspond à un condensateur CA2 comportant une armature commune avec le condensateur CA1.

Comme cela est représenté à la figure 1, les électrodes disposées sur les faces de la structure multicouche peuvent être recouvertes, totalement ou en partie, par un verni isolant 25.

Dans le dispositif représenté à la figure 1, les niveaux spécifiques 21, 22 de chaque électrode auxiliaire 11, 12 correspondent à des niveaux consécutifs de la structure multicouche. Dans d'autres modes de réalisation non représentés, les électrodes auxiliaires pourraient être formées sur des niveaux de la structure multicouche qui ne sont pas consécutifs, en interposant entre ces niveaux non consécutifs plusieurs couches isolantes et éventuellement des électrodes intermédiaires. Par exemple, ces électrodes intermédiaires pourraient être disposées pour former, avec l'électrode commune et la première électrode auxiliaire, ou avec une électrode auxiliaire consécutive, des unités capacitives auxiliaires correspondant à des condensateurs montés en série. Un tel mode de réalisation permettrait, entre autres, de répartir la tension appliquée entre l'électrode commune et les électrodes auxiliaires sur plusieurs condensateurs montés en série, de sorte que le diviseur capacitif pourrait encaisser des tensions plus élevées.

Dans le mode de réalisation représenté à la figure 1, la première électrode auxiliaire 11 est connectée à la seconde électrode principale 4 par l'entremise d'un conducteur électrique 31. De la même façon, la seconde électrode auxiliaire 12 est connectée à l'électrode commune 6 par l'entremise d'un conducteur électrique 32. Ainsi, la première et la seconde unité capacitive auxiliaire CA1, CA2 sont connectés en parallèle avec la seconde unité capacitive C2.

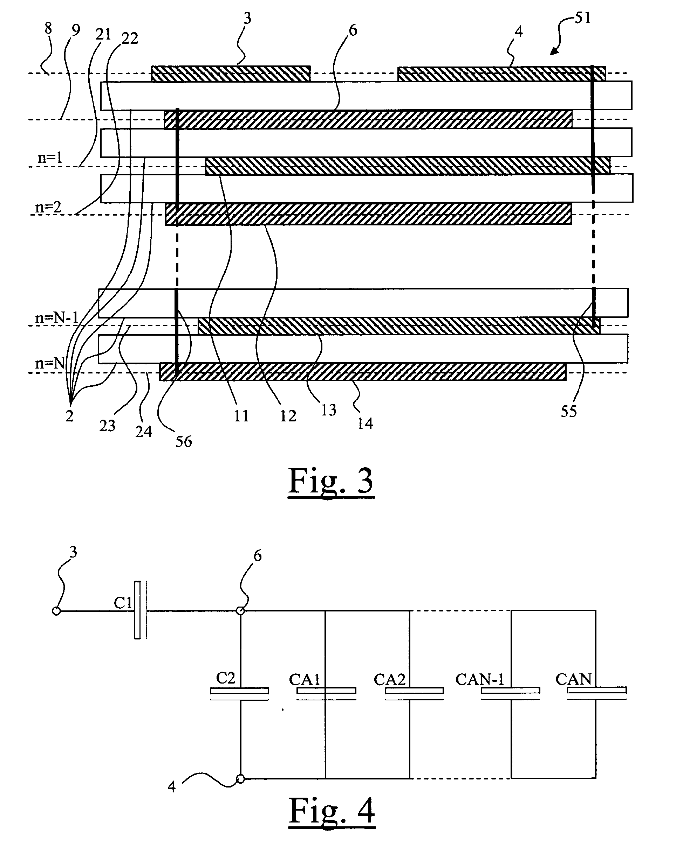

Dans le mode représenté à la figure 3, la structure multicouche 51 comporte un nombre N d'électrodes auxiliaires 11, 12, 13, 14 formées sur des niveaux spécifiques 21, 22, 23, 24 de la structure multicouche et présentant des rangs allant de 1 à N. Chaque électrode auxiliaire 11, 12, 13, 14 est disposée pour former, avec l'électrode auxiliaire formée sur un niveau spécifique consécutif, une unité capacitive auxiliaire CA1, CA2, CAN-1, CAN, comme cela est représenté sur la figure 4. Le niveau 21 de la première électrode auxiliaire 11 correspondant au rang 1. Les électrodes auxiliaires disposées sur un niveau spécifique de rang impair, telles que les électrodes 11 et 13 ayant les rangs respectifs 1 et N-1, sont connectées à la seconde électrode principale 4 par l'entremise d'un conducteur électrique 55. Les électrodes auxiliaires disposées sur un niveau spécifique de rang pair sont quant à elles connectées à l'électrode commune 6 par l'entremise d'un conducteur électrique 56, comme c'est le cas des électrodes 12 et 14 dont les rangs respectifs sont 2 et N.

Comme cela est visible sur la figure 4, grâce à ces connexions électriques des électrodes auxiliaires avec la seconde électrode principale 4 ou l'électrode commune 6, les unités capacitives CA1, CA2, CAN-1, CAN sont connectées en parallèle avec la seconde unité capacitive C2. De cette façon, la multiplication des électrodes auxiliaires permet d'augmenter significativement la valeur de la capacité équivalente entre l'électrode commune 6 et la seconde électrode principale 4. De cette façon, l'impédance d'entrée du circuit de traitement connecté entre l'électrode commune 6 et la seconde électrode principale 4, décrit ci-après, s'en trouve minimisée.

La multiplication des électrodes auxiliaires implique une augmentation de l'épaisseur de la structure multicouche par ajout de couches supplémentaires, la longueur et de la largeur de ladite structure restant inchangées. L'épaisseur de la structure multicouche peut être supérieure quelque dizaines de micron, notamment supérieure à 50 microns, par exemple de 150 microns. L'épaisseur de la structure multicouche dépend généralement du nombre de niveaux. L'épaisseur de la structure multicouche entre chaque niveau peut être inférieure à 50 microns, par exemple égale à 45 microns. L'augmentation de l'encombrement qui en résulte reste très limitée par rapport à une structure multicouche comportant un nombre de couches moindre sur laquelle les électrodes auraient été multipliées dans le sens de la longueur et/ou de la largeur.

Dans les modes représentés sur les figures 1 et 3, chaque électrode auxiliaire 11, 13 formée sur un niveau de rang impair 1, N-1 s'étend vers un côté de la structure multicouche dans lequel est disposée la seconde électrode principale 4. En l'occurrence, chaque électrode auxiliaire 11, 13 formée sur un niveau de rang impair 1, N-1 s'étend vers la droite de la structure multicouche 1, 51, en dépassant les électrodes auxiliaires 12, 14 formée sur un niveau de rang pair 2, N, c'est-à-dire que chaque électrode formée sur un niveau 12, 14 de rang pair est en retrait par rapport au côté de la structure multicouche dans lequel est disposée la seconde électrode principale 4. Chaque électrode auxiliaire 12, 14 formée sur un niveau de rang pair 2, N, ainsi que l'électrode commune 6 s'étendent, quant à elles, vers un côté latéralement opposé par rapport au côté de la structure multicouche sur lequel est disposée la seconde électrode principale 4. En l'occurrence, chaque électrode auxiliaire 12, 14 formée sur un niveau de rang pair 2, N s'étend vers la gauche de la structure multicouche 1, 51, en dépassant les électrodes auxiliaires 11, 13 formée sur un niveau de rang pair 1, N-1, c'est-à-dire que chaque électrode formée sur un niveau 11, 13 de rang impair est en retrait par rapport au côté latéralement opposé de la structure multicouche. Grâce à cette configuration, les électrodes sont connectées entre elles par l'entremise de conducteurs linéaires 31, 32, 55, 56 traversant les couches isolantes. Ces conducteurs linéaires 31, 32, 55, 56 sont également qualifiés de vias.

Dans d'autres modes de réalisation non représentés, les extensions des électrodes auxiliaires et de l'électrode commune d'un côté ou de l'autre, telles que décrites ci-dessus, pourrait aller jusqu'au bord de la structure multicouche. De cette façon, les conducteurs linéaires pourraient être disposés sur les bords de chaque côté de la structure multicouche.

Les électrodes peuvent être fabriquées dans tout matériau conducteur de l'électricité, tel que par exemple du cuivre ou de l'aluminium. Les couches isolantes peuvent, quant à elles, être fabriquées dans n'importe quel matériau diélectrique, tel que par exemple les composés époxy ou les composés polyimides, par exemple le kapton.

La structure multicouche du diviseur capacitif est généralement obtenue par toute technologie de fabrication de circuits imprimés connue. De cette façon, on obtient des diviseurs capacitifs à moindre coût, avec une bonne reproductibilité. La forme de ces structures multicouches peut être quelconque, et s'adapter à la forme des supports sur lesquels elles sont disposées. La connexion électrique entre le diviseur capacitif et le circuit de traitement associé peut être réalisée par tout moyen connu de l'homme du métier. Par exemple, cette connexion peut être réalisée à l'aide d'un fil conducteur électrique soudé entre les électrodes 4 et 6 du diviseur capacitif et des bornes d'entrées du circuit de traitement. Avantageusement, les électrodes de connexion de la structure multicouche, et les couches isolantes les supportant, peuvent être prolongées pour être connectées au circuit de traitement. Généralement, les prolongements des électrodes de connexion et de leurs couches isolantes associées sont souples, ce qui rend la connectique flexible. Préférentiellement, le circuit de traitement et le diviseur capacitif sont formés sur un même substrat.

Un avantage des diviseurs capacitifs décrits ci-dessus est qu'ils sont fabriqués sur un même substrat ou sur une même structure multicouche. Ainsi, les première et seconde unités capacitives utilisent un même diélectrique. Grâce à cette configuration, la mesure de la tension atténuée VS est plus stable en température.

Les diviseurs capacitifs décrits ci-dessus peuvent être utilisés dans tout appareil électrique dans lequel une mesure de tension est requise. Ils sont souvent utilisés en tant que capteurs de tension ou intégrés dans un capteur de tension.

Les diviseurs capacitifs décrits ci-dessus peuvent avantageusement être utilisés dans des capteurs de tension, tels que ceux utilisés dans des déclencheurs d'appareils de protection électrique. Le déclencheur d'un appareil de protection électrique comporte généralement des capteurs de courant pour mesurer le courant circulant dans les conducteurs électriques à protéger. En fonction de la valeur de ce courant, le déclencheur peut envoyer un signal de commande de déclenchement permettant d'ouvrir les contacts mobile. On obtient donc une protection souvent qualifiée de protection thermique. L'utilisation combinée de capteurs de courant et de capteurs de tension dans le déclencheur permet, en outre, de déterminer la puissance et/ou le facteur de puissance dans les conducteurs électriques à protéger. De cette façon, la commande de déclenchement peut être activée, non seulement en fonction de la valeur du courant électrique, mais également en fonction de la valeur de la tension, voire en fonction de valeurs de puissance et/ou de facteur de puissance calculées en fonction de la tension et du courant. On obtient ainsi une protection thermique améliorée.

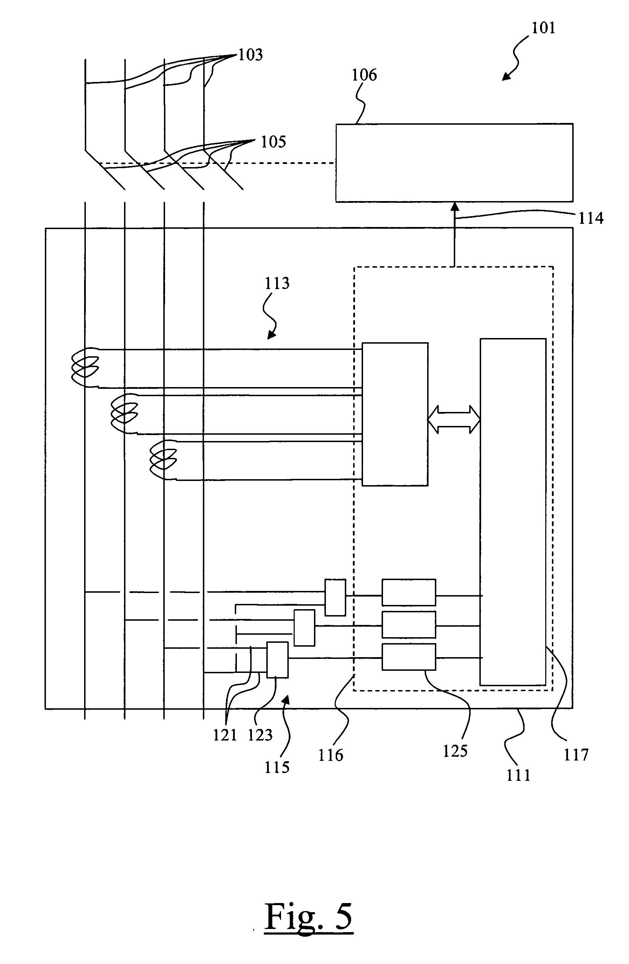

En référence à la figure 5, un tel appareil de protection électrique référencé 101 permet de protéger les conducteurs électriques 103 par activation de l'ouverture des contacts mobiles 105 disposés sur lesdits conducteurs. L'ouverture des contacts mobiles 105 est réalisée par l'entremise d'un mécanisme 106 coopérant avec lesdits contacts mobiles. L'appareil de protection électrique 101 est équipé d'un déclencheur 111 comportant des capteurs de courant 113 permettant de mesurer l'intensité du courant circulant dans les conducteurs 103 et d'envoyer un signal de commande 114 de déclenchement au mécanisme 106 en fonction de la valeur dudit courant. Le déclencheur 111 comporte, en outre, des moyens de traitement 116 permettant de fournir le signal de commande 114 de déclenchement. Les moyens de traitement 116 se présentent généralement sous la forme d'un circuit électronique sur lequel sont connectées les bobines des capteurs de courant. Généralement, les moyens de traitement permettent, entre autres, de déterminer les valeurs d'une fonction du courant représentative de l'échauffement des équipements à protéger, par exemple d'un moteur disposé en aval de l'appareil de protection électrique 101. Cette fonction du courant représentative de l'échauffement peut être égale au produit du carré du courant par une durée. Lorsque la valeur de cette fonction dépasse un seuil prédéterminé, les moyens de traitement 116 du déclencheur 111 permettent de générer et d'envoyer vers le mécanisme de déclenchement 106 un signal de commande de déclenchement 114, pour ouvrir les contacts mobiles sur les lignes à protéger.

Dans l'appareil de protection électrique représenté à la figure 5, le déclencheur 111 comporte, en outre, trois capteurs de tension 115 permettant de mesurer la tension entre les conducteurs électriques 103. Les moyens de traitement 116 du déclencheur sont connectés, non seulement aux bobines des capteurs de courant, mais également aux diviseurs capacitifs 123 des capteurs de tension 115. Dans le mode de réalisation de la figure 5, les capteurs de courant et de tension 113, 115 sont connectés à des moyens 117 de détermination de la puissance et/ou du facteur de puissance intégrés dans les moyens de traitement 116 du déclencheur 111. Ces valeurs de puissance et/ou du facteur de puissance peuvent être utilisées pour générer le signal de commande du déclenchement 114 et permettre éventuellement d'estimer l'efficacité énergétique de l'installation protégée par l'appareil de protection électrique.

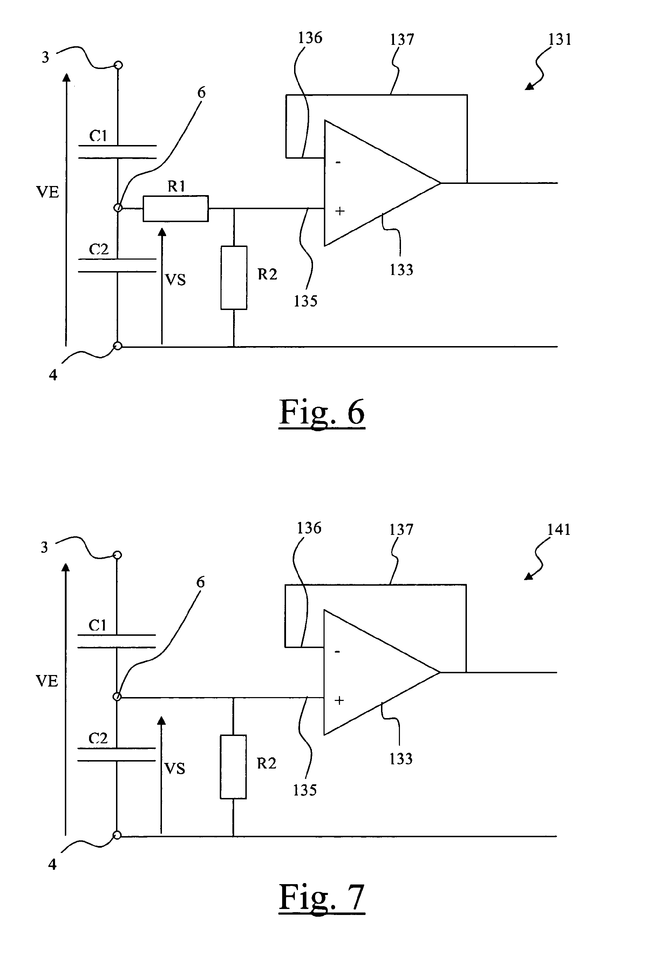

Chaque capteur de tension 115 comporte deux bornes d'entrée 121 d'une tension d'entrée VE, un dispositif diviseur capacitif 123 connecté aux dites bornes d'entrée pour fournir une tension atténuée VS en fonction de ladite tension d'entrée, et un circuit de traitement 125 connecté au dit dispositif diviseur pour fournir un signal représentatif de ladite tension d'entrée. Le diviseur capacitif 123 est intégré dans une structure multicouche telle que décrite précédemment, comportant une première et une seconde électrode principale 3, 4, représentées sur les figures 1 et 3, respectivement connectées aux dites bornes d'entrée 121. Le diviseur capacitif comporte également une électrode commune 6, également représentée sur les figures 1 et 3, connectée au circuit de traitement 125, ledit circuit faisant partie des moyens de traitement 116 du déclencheur 111. Plus précisément, la tension de atténuée VS de chaque diviseur capacitif 123 est fournie entre l'électrode commune 6 et la seconde électrode principale 4, ces deux électrodes étant connectées au circuit de traitement 125. Le circuit de traitement 125 comporte des moyens de filtrage ou d'adaptation d'impédance, permettant d'obtenir une impédance d'entrée presque infinie et une impédance de sortie réduite, tout en maintenant un gain en tension unitaire. Deux modes de réalisation de ces moyens d'adaptation d'impédance sont représentés sur les figures 6 et 7.

En référence à la figure 6, les moyens d'adaptation d'impédance 131 sont connectés entre l'électrode commune 6 et la seconde électrode principale 4, c'est-à-dire entre les armatures de la seconde unité capacitive C2. Les moyens d'adaptation d'impédance 131 comportent des moyens amplificateurs 133 pourvus d'une entrée non-inverseuse 135, d'une entrée inverseuse 136, et d'une boucle de contre-réaction 137 sur ladite entrée inverseuse. En l'occurrence, les moyens amplificateurs 133 sont essentiellement constitués par un amplificateur opérationnel connecté en mode suiveur. L'électrode commune 6 du dispositif diviseur capacitif est connectée à l'entrée non-inverseuse par l'entremise de moyens résistifs.

Dans le mode de réalisation représenté à la figure 6, les moyens résistifs comportent une première résistance R1 connectée entre l'entrée non-inverseuse 135 et l'électrode commune 6 du dispositif diviseur capacitif. Les moyens résistifs comportent, en outre, une seconde résistance R2 connectée entre l'entrée non-inverseuse 135 et la seconde électrode principale 4. Cette seconde résistance R2 est une résistance de polarisation permettant de polariser l'amplificateur opérationnel pour un bon fonctionnement du montage suiveur. La valeur de l'impédance des première et seconde résistances R1, R2 montées en série est généralement choisie très supérieure à l'impédance des première et seconde unités capacitives C1, C2 montées en parallèle, pour des fréquences d'utilisation souvent de 50 ou de 60 Hz. De cette façon, le capteur de tension fonctionne correctement et de façon répétable quelque soient les variations de température.

Dans le mode de réalisation représenté à la figure 7, les moyens d'adaptation d'impédance 141 comportent la plupart des composants décrits ci-dessus. A la différence avec le montage représenté à la figure 6, les moyens résistifs entre l'électrode commune 6 du dispositif diviseur capacitif et l'entrée non-inverseuse ne comportent pas de première résistance R1. En d'autres termes, l'entrée non-inverseuse 135 est directement connectée à l'électrode commune 6 du dispositif diviseur capacitif. La valeur de l'impédance de la seconde résistance R2 est généralement choisie très supérieure à l'impédance des première et seconde unités capacitives C1, C2 montées en parallèle, pour des fréquences d'utilisation souvent de 50 ou de 60 Hz. De cette façon, le capteur de tension fonctionne correctement et de façon répétable quelque soient les variations de température.

Dans le montage représenté à la figure 6, les premières et secondes résistances R1, R2 forment un pont diviseur. Pour ne pas dégrader la mesure de tension, ces résistances R1, R2 doivent généralement présenter une tolérance faible. La fréquence de coupure d'un tel dispositif doit généralement être choisie au moins dix fois inférieure à la fréquence la plus basse d'utilisation, cette dernière étant en l'occurrence égale à 50 ou 60 Hz. Pour cela, il est possible de choisir une seconde résistance R2 présentant une impédance élevée, par exemple de l'ordre de quelques millions d'ohms. Cependant ces résistances sont généralement coûteuses et peuvent être difficiles à approvisionner. L'utilisation d'une structure multicouche telle que décrite précédemment permet d'utiliser, avec un encombrement minimum, une unité capacitive C2 ayant une capacité plus élevée pouvant être associée avec une seconde résistance R2 de valeur plus faible. Ainsi, la stabilité en température du dispositif est assurée.

Dans le montage de la figure 7, l'impédance de la seconde résistance R2 étant très supérieure à celle de la seconde unité capacitive C2, la tolérance de la seconde résistance R2 peut être plus large sans dégrader les performances, et les problèmes de coût et d'approvisionnement évoqués ci-dessus s'en trouvent minimisés.

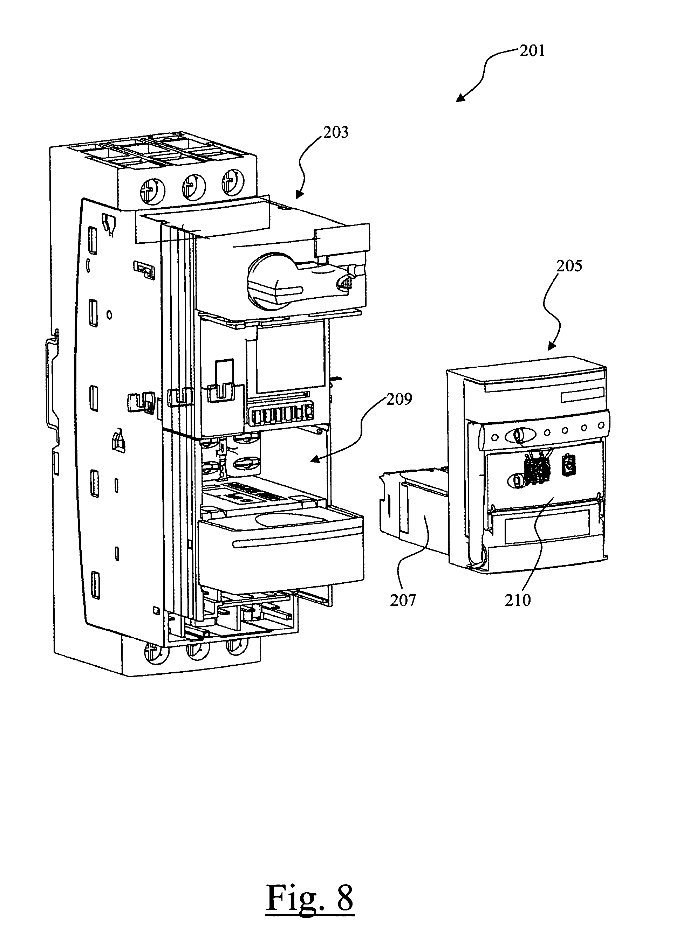

Le diviseur capacitif décrit précédemment peut être mis en oeuvre sur n'importe quel appareil de protection électrique, tel que l'appareil de commande puissance représenté à la figure 8. Cet appareil, qui présente une fonction de protection électrique, est également appelé départ moteur complet.

En référence à la figure 8, l'appareil de commande puissance 201 comportent des moyens de sectionnement, des moyens de protection contre les courts-circuits, des moyens de protection thermique et un contacteur. Plus précisément, l'appareil 201 comprend une embase 203 comportant des conducteurs électriques des lignes de puissance à protéger, des contacts mobiles sur lesdits conducteurs, un mécanisme de déclenchement pour ouvrir les contacts mobiles en réponse à un défaut électrique, ainsi qu'un contacteur. L'appareil 201 comprend également un déclencheur permettant d'envoyer, vers le mécanisme de déclenchement, un signal de commande de déclenchement en réponse à un défaut électrique. Ce déclencheur peut être également qualifié d'unité de contrôle et constituer la partie « intelligente » de l'appareil de commande puissance 201. Ce déclencheur comprend généralement les moyens de protection contre les courts-circuits et les moyens de protection thermique. Dans le mode de réalisation représenté, ce déclencheur se présente sous la forme d'un module 205 détachable de l'embase 203.

Comme cela est représenté à la figure 8, le module 205 est pourvu d'un boîtier comportant une première partie 207 destinée à être insérée à travers une ouverture 209 de l'embase 203. Dans le mode de réalisation présenté, cette première partie 207 du boîtier comporte l'ensemble de la connectique avec l'embase 205. Le boîtier du module 205 comprend, en outre, une seconde partie frontale 210 dans laquelle sont logés les moyens de traitement permettant, entre autres, de générer et d'envoyer un signal de déclenchement vers le mécanisme de déclenchement logé dans l'embase.

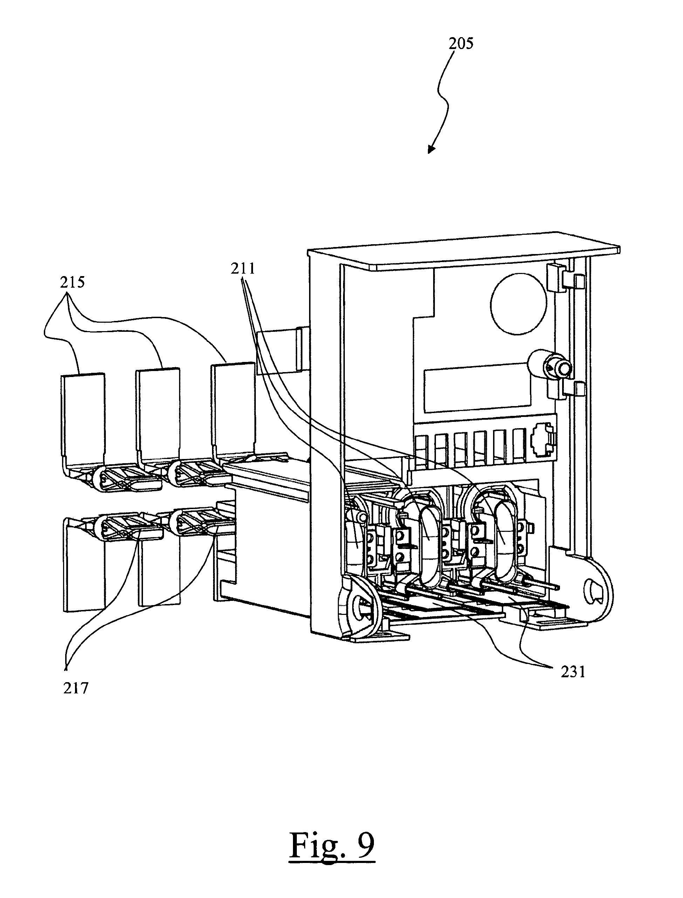

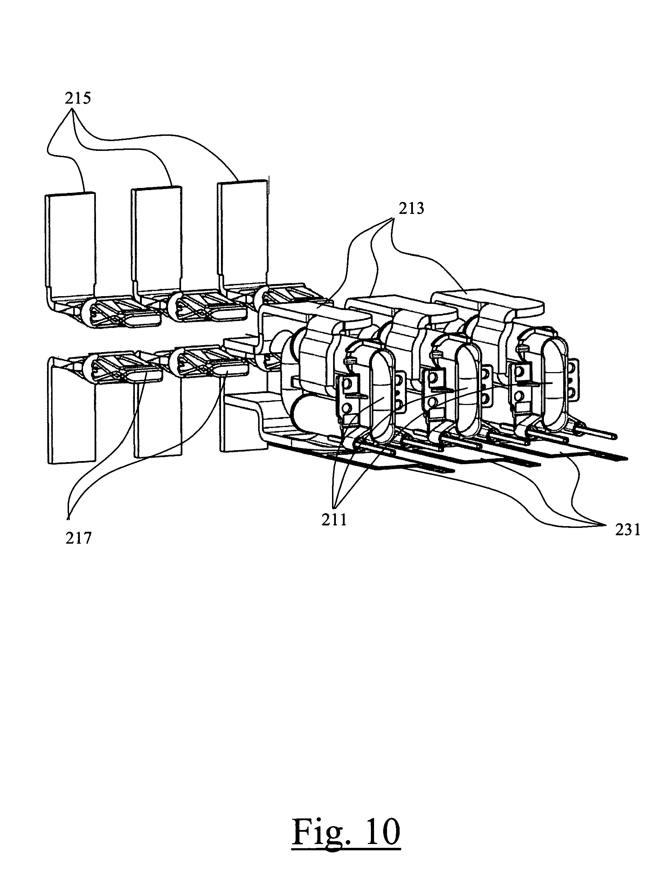

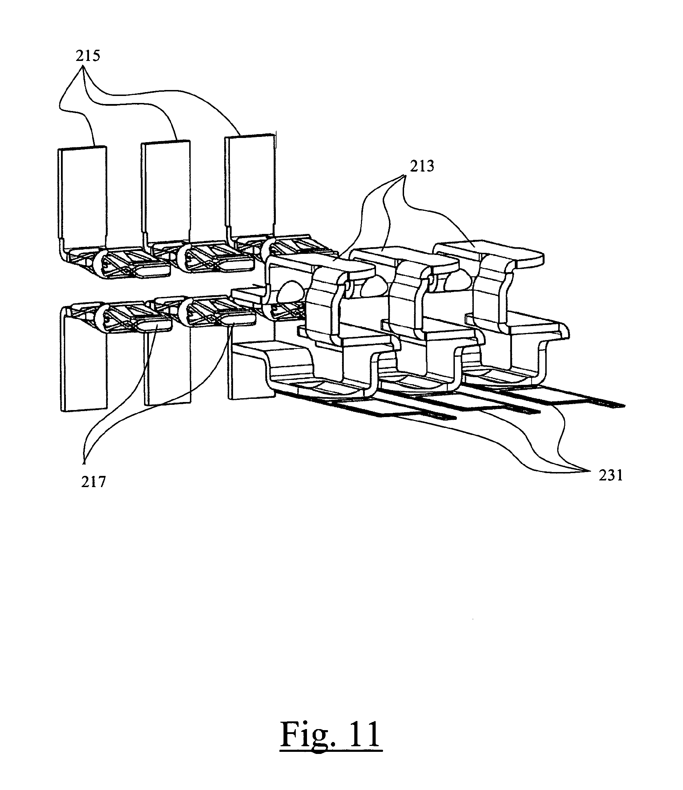

Comme cela est visible sur les figures 9 et 10, le module 205 du déclencheur comprend trois capteurs de courant 211, en l'occurrence des tores de Rogowski, permettant de mesurer le courant circulant dans les conducteurs électriques à protéger. Les capteurs de courant sont enroulés autour de conducteurs électriques 213 déportés dans le module 205 et visibles sur les figures 10 et 11. Ces conducteurs électriques 213 du module 205 sont connectés aux conducteurs électriques 215 de l'embase 203 par l'entremise de connecteurs à pinces 217. Comme cela est visible sur la figure 10, les conducteurs électriques 213 du module 205 sont conformés pour pouvoir recevoir les capteurs de courant 211 avec un minimum d'encombrement. De cette façon, le volume de la première partie 207 du boîtier du module 205 s'en trouve minimisé.

Pour permettre une protection thermique améliorée, le module 205 du déclencheur comporte des capteurs de tension. Comme cela est visible sur la figure 9, la majeure partie du volume de la première partie 207 du boîtier est occupée par les conducteurs électriques 213 et les capteurs de courant 211. La place disponible pour connecter et loger des capteurs de tension est donc très réduite.

Il a été trouvé que l'utilisation d'un capteur de tension présentant une structure multicouche, telle que décrite précédemment, permettait de pouvoir loger lesdits capteurs dans l'espace réduit et encombré de la première partie 207 du boitier du module 205. Plus précisément, comme cela est visible sur les figures 9 à 11, les capteurs de tension comportent des dispositifs diviseurs capacitifs 231 directement fixés sur une face de chaque conducteur électrique 213 du module 205. Les moyens de fixation utilisables peuvent être une colle conductrice, une soudure, ou tout moyen connu pour obtenir un contact électrique direct entre un conducteur électrique et une électrode du dispositif diviseur capacitif. Grâce aux dimensions réduites des structures multicouches dans lesquelles sont formés les dispositifs diviseurs capacitifs, lesdits dispositifs peuvent être logés dans l'espace réduit entre le conducteur électrique 213 et la première partie 207 du boîtier.

Le dispositif diviseur capacitif décrit précédemment, ainsi que tout capteur de tension équipé d'un tel dispositif, sont particulièrement adapté à tout appareil électrique comportant un grand nombre de composants ou des composants de grande taille disposés dans un espace limité.

## Revendications

1. Dispositif diviseur capacitif destiné à atténuer une tension d'entrée (VE), ledit dispositif comportant des électrodes formées sur différents niveaux d'une structure multicouche (1 ; 51) séparés par des couches isolantes (2), lesdites électrodes incluant une première et une seconde électrode principale (3, 4) pour appliquer ladite tension d'entrée, et une électrode commune (6) pour fournir une tension atténuée (VS) à partir de ladite tension d'entrée,
**caractérisé en ce que** lesdites première et seconde électrodes principales sont formées sur un même niveau (8) de ladite structure, l'électrode commune étant formée sur un autre niveau (9) de ladite structure, ladite électrode commune étant disposée pour former avec la première électrode principale une première unité capacitive (C1), et pour former avec la seconde électrode principale une seconde unité capacitive (C2),
**en ce que** ledit dispositif comporte au moins une première électrode auxiliaire (11) formée sur encore un autre niveau (21) de la structure multicouche (1 ; 51) et disposée pour former avec l'électrode commune (6) une première unité capacitive auxiliaire (CA1), et
**en ce que** ladite électrode auxiliaire (11) et la seconde électrode principale (4) s'étendent vers un côté de la structure multicouche de façon à connecter électriquement ladite électrode auxiliaire à la seconde électrode principale par l'entremise d'un conducteur linéaire (31; 55).

2. Dispositif selon la revendication 1, **caractérisé en ce que** l'électrode commune (6) est formée sur un niveau consécutif (9) par rapport au niveau (8) des dites première et seconde électrodes principales (3, 4).

3. Dispositif selon l'une quelconque des revendications 1 ou 2, **caractérisé en ce qu'**il comporte une pluralité d'électrodes auxiliaires (11-14) formées sur des niveaux spécifiques (21-24) de la structure multicouche (1 ; 51), chaque électrode auxiliaire étant disposée pour former, avec l'électrode auxiliaire formée sur un niveau spécifique consécutif, une unité capacitive auxiliaire (CA1, CA2, CAN-1, CAN), lesdites électrodes auxiliaires étant connectées soit à la seconde électrode principale (4), soit à l'électrode commune (6), de façon à obtenir une connexion en parallèle de chaque unité capacitive auxiliaire (CA1, CA2, CAN-1, CAN) avec la seconde unité capacitive (C2).

4. Dispositif selon la revendication 3, **caractérisé en ce qu'**il comporte un nombre prédéterminé N d'électrodes auxiliaires formées sur es niveaux spécifiques de la structure multicouche présentant des rangs (n) allant de 1 à N, le niveau spécifique (21) de la première électrode auxiliaire (11) correspondant au rang 1, une électrode auxiliaire (11, 13) disposée sur un niveau spécifique (21, 23) de rang impair étant connectée à la seconde électrode principale (4), une électrode auxiliaire (12, 14) disposée sur un niveau spécifique (22, 24) de rang pair étant connectée à l'électrode commune (6).

5. Dispositif selon la revendication 4, **caractérisé en ce que** chaque électrode auxiliaire (11, 13) formée sur un niveau spécifique (21, 23) de rang impair s'étend vers le côté de la structure multicouche dans lequel est disposée la seconde électrode principale (4), chaque électrode auxiliaire (12, 14) formée sur un niveau spécifique (22, 24) de rang pair et l'électrode commune (6) s'étendant vers un côté latéralement opposé, de façon à connecter les électrodes entre elles par l'entremise de conducteurs linéaires (31, 32 55 , 56).

6. Dispositif selon l'une quelconque des revendications 1 à 5, **caractérisé en ce qu'**au moins un conducteur linéaire (31, 32 ; 55, 56) traverse des niveaux consécutifs de la structure multicouche.

7. Dispositif selon l'une des revendications 3 à 6, **caractérisé en ce que** les niveaux spécifiques (21, 22, 23, 24) de chaque électrode auxiliaire (11, 12, 13, 14) correspondent à des niveaux consécutifs de la structure multicouche.

8. Capteur de tension comportant :
- deux bornes d'entrée (121) d'une tension d'entrée (VE),
- un dispositif diviseur capacitif (123) connecté aux dites bornes d'entrée pour fournir une tension atténuée (VS) en fonction de ladite tension d'entrée, et
- un circuit de traitement (125) connecté au dit dispositif diviseur pour fournir un signal représentatif de ladite tension d'entrée,
**caractérisé en ce que** ledit dispositif diviseur capacitif est un diviseur selon l'une quelconque des revendications précédentes, lesdites bornes d'entrée étant respectivement connectées à la première et à la seconde électrode principale (3, 4), ledit circuit de traitement étant connecté à l'électrode commune (6).

9. Capteur de tension selon la revendication 8, **caractérisé en ce que** le circuit de traitement (125) comporte des moyens d'adaptation d'impédance (131 ; 141).

10. Capteur de tension selon la revendication 9, **caractérisé en ce que** les moyens d'adaptation d'impédance comportent une résistance (R2) montée en parallèle avec l'unité capacitive (C2), la valeur de ladite résistance étant choisie de façon à minimiser la fréquence de coupure par rapport à la fréquence d'utilisation.

11. Module de déclencheur (111 ; 205) pour appareil de protection électrique (101 ; 201), ledit module comprenant au moins un capteur de courant (113 ; 211) pour mesurer le courant circulant dans au moins un conducteur électrique (103 ; 215, 217) protégé par ledit appareil et des moyens de traitement (116) pour fournir un signal de déclenchement (114) en fonction de la valeur dudit courant,
**caractérisé en ce que** ledit module comporte un capteur de tension (115) selon l'une quelconque des revendications 8 à 10, lesdits moyens de traitement (116) comportant des moyens (117) de détermination d'une puissance et/ou d'un facteur de puissance connectés au dit capteur de courant et au dit capteur de tension, ledit signal de déclenchement étant fonction, entre autres, de la valeur de ladite puissance et/ou dudit facteur de puissance.

12. Appareil de protection électrique (101, 201) destiné à être installé sur au moins un conducteur électrique (103 ; 215, 217), ledit appareil comprenant un contact mobile (105), un mécanisme (106) de commande d'ouverture ou de fermeture dudit contact mobile, et un déclencheur (111) coopérant avec ledit mécanisme pour déclencher l'ouverture dudit contact mobile en réponse à un défaut électrique, **caractérisé en ce que** ledit déclencheur comprend un module de déclencheur (205) selon la revendication précédente, ledit module étant pourvu d'un capteur de tension (115 ; 231) et d'un capteur de courant (113 ; 211).

13. Appareil de protection électrique (101 ; 201) destiné à être installé sur au moins un conducteur électrique (103 ; 215, 217), ledit appareil comprenant un contact mobile (105), un mécanisme (106) de commande d'ouverture ou de fermeture dudit contact mobile, et un déclencheur (111 ; 205) coopérant avec ledit mécanisme pour déclencher l'ouverture dudit contact mobile en réponse à un défaut électrique, ledit déclencheur comprenant un capteur de courant (113 ; 211) pour mesurer le courant circulant dans ledit conducteur électrique et des moyens de traitement (116) pour fournir un signal de déclenchement (114) fonction dudit courant,
**caractérisé en ce que** le déclencheur comprend, en outre, un capteur de tension (115 ; 231) selon l'une quelconque des revendications 8 à 10, lesdits moyens de traitement (116) comportant des moyens (117) de détermination d'une puissance et/ou d'un facteur de puissance connectés au dit capteur de courant et au dit capteur de tension, ledit signal de déclenchement étant fonction de ladite valeur de la puissance et/ou dudit facteur de puissance.
